# EUROPEAN PATENT APPLICATION

(11) **EP 2 138 858 A2**
(43) Date of publication of application: **30.12.2009**
(21) Application number: 09163469.1
(22) Date of filing: 23.06.2009
(51) Int. Cl.: G01R 31/36

(54) **Battery management system and driving method thereof**

(30) Priority: 24.06.2008 KR 20080059600
(71) Applicant: Samsung SDI Co., Ltd., Gyeonggi-do (KR)
(72) Inventor: Lim, Gye-Jong, Gyeonggi-do (KR)
(74) Representative: Walaski, Jan Filip

(57) **Abstract**

A battery management system, and a driving method thereof, includes a sensing unit and an MCU. The sensing unit stores a detection voltage that corresponds to a cell voltage of a first battery among a plurality of battery cells, and measures a current of the battery at an end point of storing of the detection voltage. The MCU controls the sensing unit to measure the battery current at the end point of storing of the detection voltage.

## Description

The present invention relates to a battery management system and a driving method thereof.

Vehicles using an internal combustion engine powered by gasoline (petrol) or diesel have caused serious air pollution. Accordingly, various efforts for developing electric or hybrid vehicles have recently been undertaken so as to reduce air pollution.

An electric vehicle uses an electric motor operating by electrical energy output by a battery. Since the electric vehicle mainly uses a battery formed by one battery pack including a plurality of rechargeable secondary cells, electric vehicles produce no emission gases and less noise.

A hybrid vehicle commonly refers to a gasoline-electric hybrid vehicle that uses gasoline to power an internal-combustion engine and a battery to power an electric motor. Recently, hybrid vehicles using an internal-combustion engine and fuel cells and hybrid vehicles using a battery and fuel cells have been developed. The fuel cells directly obtain electrical energy by generating a chemical reaction while hydrogen and oxygen are continuously provided thereto.

In order to enhance output power of a vehicle using a battery as a power source, the number of rechargeable battery cells has increased, and a battery management system (BMS) is used to efficiently manage a plurality of cells connected to each other.

Particularly, the BMS estimates a state of charge (SOC) and a state of health (SOH) of the battery by measuring an open circuit voltage (OCV) and a current value upon starting an engine of the vehicle. In this case, a switch may be used for measuring the OCV and the current value.

When the OCV and the current value are measured using the switch, timing for measuring the OCV and the current value may be changed due to the turning on/off of the switch. For example, turn-on and turn-off timing of the switch may cause the current value of the battery to be measured earlier for a predetermined time period than the OCV measuring timing so that the BMS may measure a current value before the predetermined time period. As described, turn-on/off operation of the switch may cause timing for measuring the OCV and the current value to be changed.

Aspects of the present invention provide a battery management system that can control timing for measuring a battery cell voltage and a battery current, and a driving method thereof.

An exemplary battery management system (BMS) according to aspects of the present invention manages a battery having a plurality of battery cells.

According to aspects of the present invention, the BMS includes a sensing unit to store a detection voltage that corresponds to a cell voltage of a first cell among the plurality of battery cells and to measure a current of the battery upon completing storage of the detection voltage, and an MCU to control the sensing unit to measure the current of the battery upon completing storage of the detection voltage.

An exemplary BMS according to aspects of the present invention includes a plurality of cells and a plurality of cell relays respectively connected to the plurality of cells.

According to aspects of the present invention, the BMS includes a current sensor to sense a current of a battery, a sensing unit to store a detection voltage that corresponds to a battery cell voltage transmitted through one of the plurality of cell relays and to control the current sensor to measure the battery current upon completing storage of the detection voltage, and an MCU to control the sensing unit to measure the battery current upon completing storage of the detection voltage. According to aspects of the present invention, the sensing unit generates a signal corresponding to the detection voltage at a time after completing storage of the detection voltage.

An exemplary driving method according to aspects of the present invention drives a BMS that includes a plurality of cells and a plurality of cell relays respectively connected to the plurality of cells.

According to aspects of the present invention, the driving method includes storing a detection voltage that corresponds to a cell voltage transmitted through one of the plurality of cell relays, measuring a battery current upon completion of the storing of the detection voltage, and measuring the detection voltage after the completion of the storing of the detection voltage.

As described above, according to aspects of the present invention, a battery cell voltage and a battery current can be accurately measured by controlling timing for measuring the battery cell voltage and the battery current, and accordingly, an accurate SOC can be estimated.

Additional aspects and/or advantages of the invention will be set forth in part in the description which follows and, in part, will be obvious from the description, or may be learned by practice of the invention.

These and/or other aspects and advantages of the invention will become apparent and more readily appreciated from the following description of the embodiments, taken in conjunction with the accompanying drawings, in which:
FIG. 1 is a schematic diagram of a battery, a battery management system, and peripheral devices according to aspects of the present invention.
FIG. 2 is a schematic configuration of the battery management system of FIG. 1.
FIG. 3 is a schematic diagram of a sensing unit and an MCU according to aspects of the present invention.
FIG. 4 is a detailed view of a voltage detection unit of the sensing unit of FIG. 3.
FIG. 5 is a timing diagram for measuring a cell voltage and a current of the battery according to aspects of the present invention.
FIG. 6 is a flowchart of a process for measuring the cell voltage and the current of the battery according to aspects of the present invention.

Reference will now be made in detail to aspects of the present invention, examples of which are illustrated in the accompanying drawings, wherein like reference numerals refer to the like elements throughout. The aspects are described below in order to explain the present invention by referring to the figures. As those skilled in the art would realize, the described aspects may be modified in various different ways. Accordingly, the drawings and description are to be regarded as illustrative in nature and not restrictive. In addition, unless explicitly described to the contrary, the word "comprise" and variations, such as "comprises" or "comprising," will be understood to imply the inclusion of stated elements but not the exclusion of any other elements.

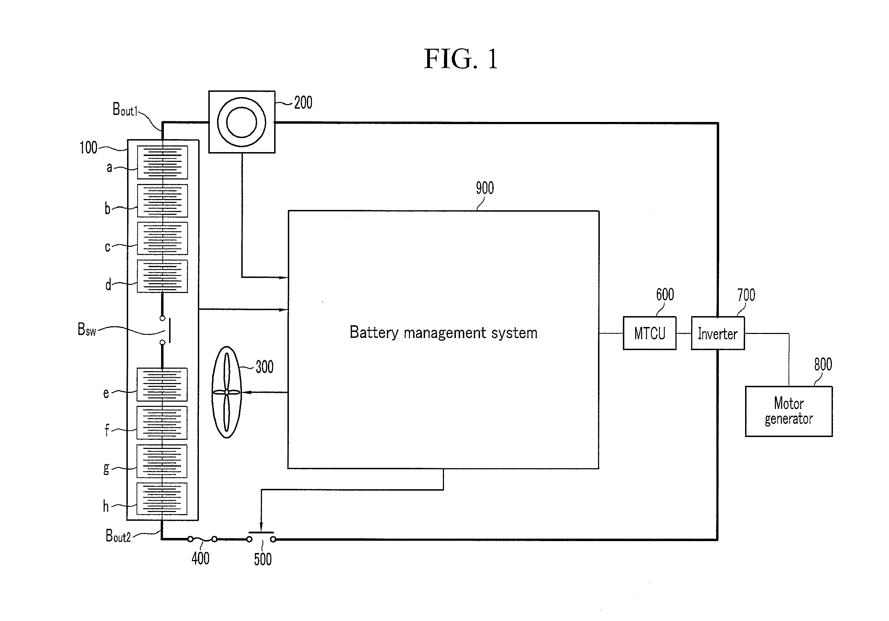

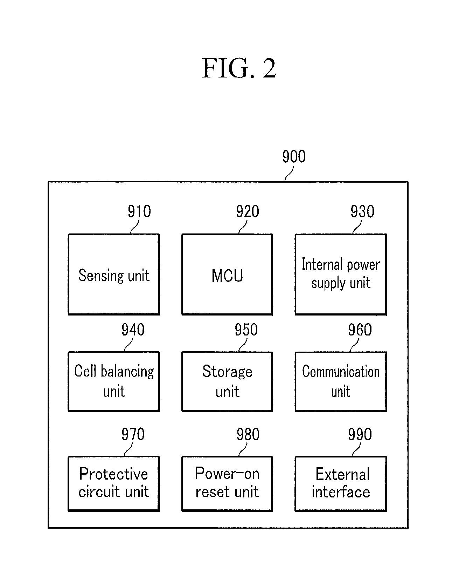

A battery management system and a driving method thereof according to aspects of the present invention will be described in further detail with reference to the drawings. FIG. 1 is a schematic diagram of a battery, a battery management system, and peripheral devices according to aspects of the present invention. FIG. 2 is a schematic configuration of the battery management system of FIG. 1. Additionally, a vehicle system that uses a battery will be described in further detail.

As shown in FIG. 1, a vehicle system comprises a battery 100, a current sensor 200, a cooling fan 300, a fuse 400, a main switch 500, a motor control unit (MTCU) 600, an inverter 700, a motor generator 800, and a battery management system (BMS) 900.

The battery 100 includes a plurality of sub-packs a to h, each of the sub-packs a to h having a plurality of battery cells coupled in series to each other, an output terminal Bout1, an output terminal Bout2, and a safety switch BSW disposed between the sub-pack d and the sub-pack e. Eight sub-packs a to h are exemplified and one sub-pack is a group of a plurality of battery cells, but aspects of the present invention are not limited thereto such that the sub-packs may include more or fewer sub-packs included in the battery 100. The safety switch BSW is manually turned on/off to guarantee safety for a worker when performing operations on the battery or replacing the battery. In the exemplary embodiment of the present invention, the battery 100 includes the safety switch BSW, but it is not limited thereto such that the safety switch BSW need not be manually operated but may be automatically operated.

The current sensor 200 measures an output current value of the battery 100 and transmits the measured output current value to the BMS 900. In further detail, the current sensor 200 may be a Hall current transformer that measures a current by using a Hall element and outputs an analog current signal corresponding to the measured current, or may be a shunt resistor that outputs a voltage signal for a current flowing through the resistor provided on a load line.

The cooling fan 300 removes heat generated by charging or discharging the battery 100 according to a control signal supplied thereto from the BMS 900 to prevent the battery 100 from being degraded by a temperature increase and thereby preventing charging/discharging efficiency from being degraded.

The fuse 400 prevents an overcurrent, which may be caused by a disconnection or a short circuit, from being transmitted to the battery 100. That is, when the overcurrent is generated, the fuse 400 is disconnected.

The main switch 500 turns on/off the battery 100 in response to a control signal supplied thereto from the BMS 900 of a control signal of the MTCU 600 when an unusual phenomenon, including an overvoltage, an overcurrent, or a high temperature, occurs.

The MTCU 600 checks an operation state of the vehicle based on information of an accelerator, a brake, and a vehicle speed, and determines necessary information, such as a degree of torque. Here, the operation state of the vehicle may include the key-on state for starting the engine, the key-off state for stopping the engine, the coasting state, and acceleration state. The MTCU 600 controls switching of the inverter 700 and controls the motor generator 800 to have an output based on the torque information. In addition, the MTCU 600 transmits vehicle state information to the BMS 900, and receives the state of charge (SOC) of the battery 100 from the BMS 900 and controls the SOC of the battery 100 to reach a target value (e.g., 55%). For example, when the SOC received from the BMS 900 is 55% or less, the MTCU 600 controls a switch of the inverter 700 to charge the battery 100 by outputting power to the battery 100. In this case, a battery current may be set to a positive (+) value. When the SOC is 55% or more, the MTCU 600 controls the switch of the inverter 700 to discharge the battery 100 by outputting the power to the motor generator 800; and in this case, the battery current may be set to a negative (-) value. That is, the MTCU 600 prevents charging or discharging of the battery 100 on the basis of the SOC transmitted from the BMS 900. Thus, the inverter 700 enables the battery 100 to be charged or discharged based on the control signal of the MTCU 600.

The motor generator 800 drives the vehicle on the basis of the torque information received from the MTCU 600 using the electrical energy of the battery 100.

The BMS 900 estimates the SOC and the state of health (SOH) of the battery 100 by measuring a voltage, a current, and a temperature of the battery 100. In addition, the BMS 900 controls charging and discharging of the battery 100 based on the SOC and the SOH.

In further detail, referring to FIG. 2, the BMS 900 includes a sensing unit 910, a micro control unit (MCU) 920, an internal power supply unit 930, a cell balancing unit 940, a storage unit 950, a communication unit 960, a protective circuit unit 970, a power-on reset unit 980, and an external interface 990. According to aspects of the present invention, the BMS 900 is not limited thereto such that the BMS 900 may include other units not shown.

The sensing unit 910 measures a cell voltage V, a current I, and a temperature T of the battery 100 according to control of the MCU 920, i.e., the sensing unit 910 receives a control signal from the MCU 920, and measures the cell voltage V, the current I, and the temperature T of the battery 100 according to the control signal.

Here, the cell voltage V, the current I, and the temperature T of the battery 100 are measured in analog form. The sensing unit 910 converts the cell voltage V, the current I, and the temperature T of the battery 100, which are in the analog form, to digital values and transmits the digital-converted values to the MCU 920.

The MCU 920 receives the cell voltage V, the current I, and the temperature T of the battery 100 from the sensing unit 910 and measures the SOC and the SOH. In addition, the MCU 920 generates a control signal to control timing of the measuring of the cell voltage V and the current I of the battery 100.

The internal power supply unit 930 supplies power to the BMS 900 by using an auxiliary battery. The cell balancing unit 940 balances an SOC of each cell. That is, the cell balancing unit 940 can charge a cell of which an SOC is relatively high and discharge a cell of which an SOC is relatively low.

The storage unit 950 stores data including a current SOC and a current SOH when the BMS 900 is turned off. Here, the storage unit 950 may include a non-volatile electrically erasable programmable read-only memory (EEPROM), but aspects are not limited thereto such that the storage unit 950 may include a volatile memory, such as RAM, or another type of non-volatile memory, such as ROM, flash memory, or a hard disk drive.

The communication unit 960 communicates with the MTCU 600 of the vehicle. That is, the communication unit 960 transmits SOC and SOH data to the MTCU 600, or transmits a vehicle state received from the MTCU 600 to the MCU 920.
The protective circuit unit 970 is a secondary circuit for protecting the battery 100 from shock, overcurrents, and low voltages. The power-on reset unit 980 resets the overall system when the BMS 900 is turned on. The external interface 990 connects auxiliary devices of the BMS 900, such as the cooling fan 300 and the main switch 500, to the MCU 920. In the exemplary embodiment of the present invention, only the cooling fan 300 and the main switch 500 are shown as the auxiliary devices, but it is not limited thereto such that instruments to output information about the BMS 900 or other devices may be communicably connected thereto.

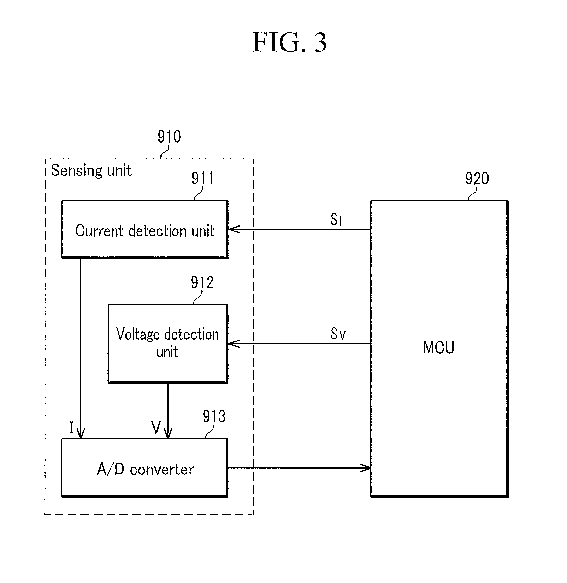

Hereinafter, a method for controlling timing of the measuring of the cell voltage and the current of the battery of the BMS according to an exemplary embodiment of the present invention will be described in further detail with reference to FIG. 3 to FIG. 6.

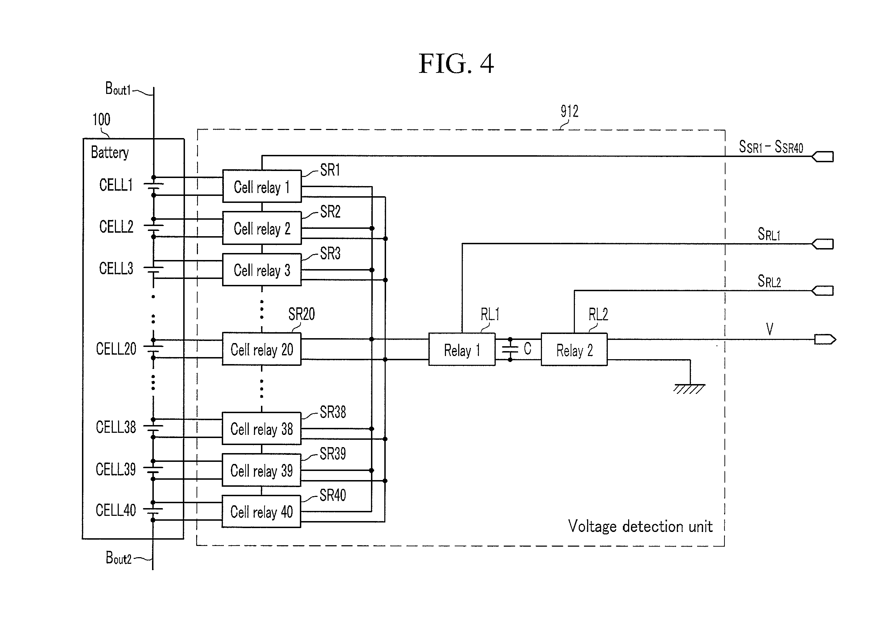

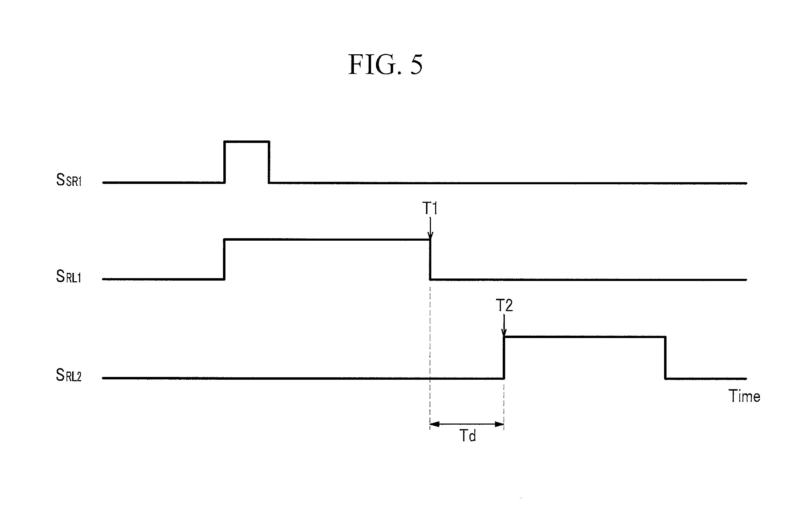

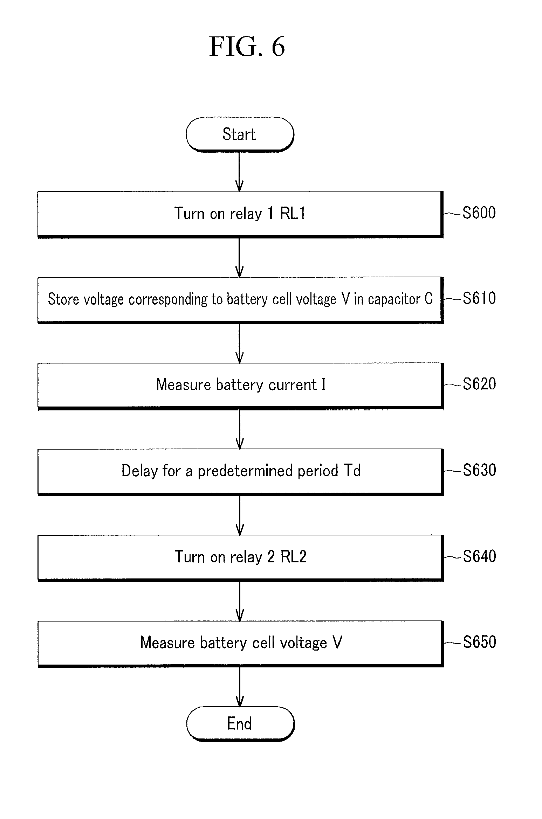

FIG. 3 schematically shows the sensing unit and the MCU according to aspects of the present invention, and FIG. 4 shows the voltage detection unit of the sensing unit of FIG. 3 in further detail. FIG. 5 shows a timing diagram for measuring a cell voltage of the battery and a current of the battery according to aspects of the present invention. FIG. 6 is a flowchart of a process for measuring the cell voltage and current of the battery according to aspects of the present invention.

As shown in FIG. 3, the MCU 920 generates a voltage control signal S_{V} and a current control signal S_{I} to control timing of the measuring of the cell voltage V and the current I of the battery, respectively. The voltage control signal S_{V} may include two or more control signals for measuring a plurality of battery cells. The voltage control signal S_{V} will be described in further detail later with reference to FIG. 4. Further, each of the voltage control signal S_{V} and the current control signal S_{I} may include one or more signals.

In further detail, the MCU 920 determines a detection voltage, which corresponds to the cell voltage V of the battery, in the voltage detection unit 912. The MCU 920 controls the current detection unit 911 to measure the current I of the battery at an end point of charging of the detection voltage. That is, the MCU 920 generates the current control signal S_{I} at the time of the end of storing of the detection voltage and transmits the current control signal S_{I} to the current detection unit 911. In addition, the MCU 920 generates the voltage control signal S_{V} for measuring a detection voltage charged after a predetermined delay time period T_{d} and transmits the voltage control signal S_{V} to the voltage detection unit 912.

The sensing unit 910 includes a current detection unit 911, a voltage detection unit 912, and an analog-to-digital (A/D) converter 913.

The current detection unit 911 controls the current sensor 200 (of FIG. 1) to measure a battery current according to the current control signal S_{I} transmitted from the MCU 920. The current detection unit 911 receives analog data for the battery current I measured by the current sensor 200. In addition, the current detection unit 911 transmits the analog data for the battery current I to the A/D converter 913.

The voltage detection unit 912 charges to a detection voltage that corresponds to the cell voltage V of the battery according to the voltage control signal Sᵥ, and transmits the charged detection voltage to the A/D converter after the predetermined delay time period T_{d}.

The voltage detection unit 912 will be described in further detail with reference to FIG. 4. As shown in FIG. 4, the voltage detection unit 912 includes a plurality of cell relays SR1 to SR40, relays RL1 and RL2, and a capacitor C.

Although the number of cell relays SR1 to SR40 is described as 40, which corresponds to the number of battery cells to 40, aspects of the present invention are not limited thereto such the number of cell relays can correspond with any number of battery cells. Further, the cell relays need not correspond to the number of battery cells such that one cell relay may correspond to multiple battery cells or multiple cell relays may correspond to a single battery cell. In this case, the voltage control signal S_{V} transmitted to the voltage detection unit 912 includes cell relay control signals S_{SR1} to S_{SR40} to respectively control the plurality of cell relays SR1 to SR40 and relay control signals S_{RL1} and S_{RL2} to respectively control the relays RL1 and RL2. The cell relays SR1 to SR40 may be respectively turned on when the cell relay control signals S_{SR1} to S_{SR40} are at high levels and may be respectively turned off when the cell relay control signals S_{SR1} to S_{SR40} are at low levels. The relays RL1 and RL2 may be respectively turned on when the relay control signals S_{RL1} and S_{RL2} are at the high level and may be respectively turned off when the relay control signals S_{RL1} and S_{RL2} are at the low level.

Each of the plurality of cell relays SR1 to SR40 are respectively connected to the plurality of cells CELL1 to CELL40 of the battery 100. Specifically, each cell relay SR1 to SR40 is respectively connected to a positive terminal and a negative terminal of one of the plurality of cells CELL1 to CELL40 of the battery 100. The plurality of cell relays SR1 to SR40 are turned on/off according to the plurality of cell relay control signals S_{SR1} to S_{SR40}. Among the plurality of cells CELL1 to CELL40, a battery cell voltage V that corresponds to a cell relay turned on through the turn-on cell relays SR1 to SR40 is transmitted to the capacitor C through a turn-on relay RL1. Through the cell relay turned on by the control signals S_{SR1} to S_{SR40} and the relay RL1 turned on by the relay control signal S_{RL1}, a corresponding cell among the plurality of cells of the battery 100 and the capacitor C are electrically connected. Then, a detection voltage that corresponds to the battery cell voltage is stored in the capacitor C through a path that includes the turned-on cell relay and the turned-on relay RL1. After the detection voltage that corresponds to the battery cell voltage is charged in the capacitor C, the MCU 920 turns on the relay RL2 after a predetermined delay time period T_{d}. In further detail, the relay RL2 is turned on/off according to the relay control signal S_{RL2} and transmits the voltage stored in the capacitor C to the A/D converter 913.

In order to accurately measure the voltage charged in the capacitor C, the relay RL1 must be completely turned off. Here, the predetermined delay time period T_{d} should be longer than a time period for completely turning off the relay RL1. When the relay RL2 is turned on after the relay RL1 is completely turned off, the detection voltage charged in the capacitor C is transmitted to the A/D converter 913 through the relay RL2.

Referring back to FIG. 3, the A/D converter 913 converts the analog data transmitted from the current detection unit 911 and the voltage detection unit 912 to digital data and transmits the digital data to the MCU 920.

Referring to FIG. 3 to FIG. 6, a process for measuring a battery cell voltage and a battery current according to aspects of the present invention will be described in further detail. For non-limiting illustrative purposes, the battery cell voltage and the battery current are measured by using a voltage stored in the cell relay SR1 among the plurality of cell relays SR1 to SR40; however, aspects of the present invention are not limited thereto.

When a high-level cell relay control signal S_{SR1} is transmitted to the cell relay SR1, the cell relay SR1 is turned on (S600). In this case, when a high-level relay control signal S_{RL1} is transmitted to the relay RL1, the battery cell voltage V stored in the cell CELL1 is stored in the capacitor C through the cell relay SR1 and the relay RL1 (S610).

At a time T1, a time at which a low-level relay control signal S_{RL1} is transmitted to the relay RL1 so that the relay RL1 is completely turned off, i.e., when the storing of a detection voltage that corresponds to the battery cell voltage V is completed, the MTCU 920 generates the current control signal S_{I} for measuring the battery current I and transmits the current control signal S_{I} to the current detection unit 911. The current detection unit 911 receives a battery current I from the current sensor 200 according to the current control signal S_{I} as an input and transmits the battery current I to the A/D converter 913 (S620).

After the predetermined delay time period T_{d}, the MCU 920 transmits a high-level control signal S_{RL2} to the relay RL2 to turn on the relay RL2 (S630 and S640). At a turn-on time point T2 of the relay RL2, the voltage detection unit 912 measures a detection voltage that corresponds to the battery cell voltage V stored in the capacitor C. That is, since the relay RL2 is turned on, the voltage detection unit 912 transmits the detection voltage from the relay RL2 to the A/D converter 913 (S650).

The A/D converter 913 converts the battery current I and the battery cell voltage V, transmitted in analog formats to digital data, and transmits the digital data to the MCU 920.

A battery current I and a battery cell voltage V of other cell relays SR2 to SR40 can be measured in the same manner as described above.

As described, according to aspects of the present invention, the battery current I is measured at the time point T1 when the relay RL1 is completely turned off and the battery cell voltage V is completely stored in the capacitor C so that the timing of the measuring of the battery cell voltage V and timing of the measuring of the battery current I can be synchronized. A time gap between the timing of the measuring of the battery cell voltage V and of the battery current I may decrease accuracy in the measurement. Therefore, according to aspects of present invention, accurate data can be obtained by synchronizing the timing of the measuring of the battery cell voltage V and the battery current I. In addition, since the relay RL2 is turned on after the relay RL1 is completely turned off, a measurement error that can occur due to a current leakage can be decreased.

Although a few embodiments of the present invention have been shown and described, it would be appreciated by those skilled in the art that changes may be made in these embodiments without departing from the principles of the invention, the scope of which is defined in the claims.

## Claims

1. A battery management system BMS for a battery having a plurality of cells, the BMS comprising:
a sensing unit (910) for storing a detection voltage that corresponds to a cell voltage of one of the plurality of battery cells and for measuring a battery current; and
a control unit (920) for controlling the sensing unit to measure the battery current after the detection voltage has been stored.

2. The BMS of claim 1, wherein the sensing unit is arranged to generate a signal corresponding to the detection voltage at a time after completing storage of the detection voltage.

3. The BMS of claim 1 or 2, wherein the control unit (920) is arranged to generate and output first, second and third control signals to the sensing unit to control the sensing unit, and the sensing unit is arranged to start and end the storing of the detection voltage according to the first control signal, to measure the current of the battery according to the second control signal (S_{I}), and to generate a signal corresponding to the detection voltage according to the third control signal (S_{V}).

4. The BMS of claim 3, further comprising a current sensor (200) to measure the battery current,
wherein the sensing unit comprises:
a current detection unit (911) to control the current sensor to measure the current of the battery according to the second control signal, and
a voltage detection unit (912) to measure the detection voltage according to the third control signal.

5. The BMS of claim 4, wherein the sensing unit further comprises an analog to digital (A/D) converter (913) to convert the detection voltage and the battery current to digital data.

6. The BMS of claim 4 or 5, wherein the third signal is arranged to be applied to the voltage detection unit after the second signal is applied to the current detection unit.

7. The BMS of any one of the preceding claims, comprising:
cell relays (SR1-40) respectively connected to the cells;
wherein the detection voltage corresponds to a battery cell voltage transmitted through one of the cell relays.

8. The BMS of claim 7 when dependent on claim 4, wherein the voltage detection unit further comprises:
a first relay (RL1) to sequentially transmit the detection voltages of each of the cells, the first relay having a first end connected to the cell relays;
a capacitor (C) to store the detection voltage of each of the cells, the capacitor having a first end connected to a second end of the first relay; and
a second relay (RL2) to transmit the detection voltage of the cell stored in the capacitor to the voltage detection unit, the second relay having a first end connected to a second end of the capacitor.

9. The BMS of claim 8, wherein the second relay is arranged to transmit the stored detection voltage after the first relay is completely turned off.

10. The BMS of claim 8 or 9, wherein the second relay is arranged to transmit the stored detection voltage of the cell after the current detection unit detects the current of the battery.

11. A driving method for a battery management system for a battery having a plurality of cells, the method comprising:
storing a detection voltage, the detection voltage corresponding to a cell voltage of one of the battery cells; and
measuring a battery current once storing of the detection voltage is complete.

12. The driving method of claim 11, further comprising:
measuring the detection voltage after the completion of the storing of the detection voltage.

13. The driving method of claim 12, further comprising:
generating a control signal to control timing of the measuring of the detection voltage and the battery current.

14. The driving method of claim 12 or 13, wherein the measuring of the detection voltage is after a predetermined time from the completion of the storing of the detection voltage.

15. The driving method of any one of claims 11 to 14, comprising:
turning on a first relay to store the detection voltage in a capacitor;
turning off the first relay when the detection voltage is stored in the capacitor;
measuring a current of the battery when the detection voltage is stored in the capacitor;
turning on a second relay to measure the detection voltage stored in the capacitor.
